# EUROPEAN PATENT APPLICATION

(11) **EP 4 737 082 A1**
(43) Date of publication of application: **06.05.2026**
(21) Application number: 24832072.3
(22) Date of filing: 28.06.2024
(51) Int. Cl.: B28D 5/00, B26F 3/00, B28D 7/04, H01L 21/301

(54) **BREAKING DEVICE AND BREAKING METHOD**

(30) Priority: 29.06.2023 JP 2023107442
(71) Applicant: Mitsuboshi Diamond Industrial Co., Ltd., Settsu, Osaka 566-0034 (JP)
(72) Inventor: TAKEDA, Masakazu, Settsu city, Osaka 566-0034 (JP); TAMURA, Kenta, Settsu city, Osaka 566-0034 (JP); NAKAGUCHI, Yuki, Settsu city, Osaka 566-0034 (JP); YAMANAKA, Ryota, Settsu city, Osaka 566-0034 (JP)
(74) Representative: TBK
(86) International application number: PCT/JP2024/023451
(87) International publication number: WO 2025/005214

(57) **Abstract**

To break a substrate with high quality, which is difficult to break, a breaking device (100) includes a table (3) and a breaking member (1). A substrate (S) having a scribe line (SL) formed is placed on the table (3). The breaking member (1) presses the substrate (S) placed on the table (3) at the part where the scribe line (SL) is formed, so as to break the substrate (S) along the scribe line (SL). The table (3) has a Young's modulus of 1 to 10 GPa.

## Description

### TECHNICAL FIELD

The present invention relates to a breaking device and a breaking method for breaking a brittle substrate.

### BACKGROUND ART

Conventionally, there is known a method of breaking (cutting) a brittle substrate, by forming a scribe line on the brittle substrate, and pressing the brittle substrate by a breaking member or the like at the part where the scribe line is formed. This breaking method is used for breaking a semiconductor substrate having a surface on which a metal film is formed (see, for example, Patent Citation 1).

### PRIOR ART CITATIONS

### PATENT CITATION

Patent Citation 1: WO2019/082736

### SUMMARY OF INVENTION

### TECHNICAL PROBLEM

When breaking the semiconductor substrate having a surface on which a metal film is formed, conventionally, the semiconductor substrate on which the scribe line is formed on a surface where the metal film is not formed is placed on a table made of an elastic material such as rubber, and the semiconductor substrate placed on the table is pressed by a breaking member, so as to break. Alternatively, a so-called "three point bending breaking" method is used for breaking a substrate.

However, in the conventional breaking method, the metal film cannot be cut by one breaking step, and it is necessary to perform the breaking step twice. As a result, quality of the substrate after cutting is not high due to occurrence of a large chipping in the cut part of the substrate, or other reason.

It is an object of the present invention to break a substrate such as a semiconductor substrate with high quality, the substrate having a metal film formed and being difficult to break.

### TECHNICAL SOLUTION

Hereinafter, a plurality of embodiments are described as means for solving the problem. These embodiments can be arbitrarily combined as necessary.

A breaking device according to one aspect of the present invention includes a table and a breaking member. A substrate on which a scribe line is formed is placed on the table. The breaking member presses the substrate placed on the table at the part where the scribe line is formed, so as to break the substrate along the scribe line. In this breaking device, the table has a Young's modulus of 1 to 10 GPa.

In the breaking device described above, the table on which the substrate to be broken is placed has a Young's modulus of 1 to 10 GPa. By using the table having the appropriate Young's modulus, when the breaking member presses the substrate, the substrate is applied with an appropriate level of force and a displacement in the substrate plane direction, and hence even a substrate that is difficult to break can be broken by one breaking step. If the breaking steps can be reduced, damage to the substrate due to the breaking step can be reduced, and it is possible to suppress occurrence of a large chipping or the like, so that high quality breaking can be realized.

In the breaking device described above, the table may be made of a resin material. The table made of a resin material has a Young's modulus suitable for breaking a substrate, and hence even a substrate that is difficult to break can be broken by one breaking step, and high quality breaking can be realized.

In the breaking device described above, the table may include a first table made of a glass member and a second table disposed on the first table. In this case, the second table may have a Young's modulus of 1 to 10 GPa. In this way, the table having an appropriate hardness can be realized.

In the breaking device described above, the substrate may include a plate-like substrate made of a brittle material, and a metal layer formed on a first surface of the plate-like substrate. The breaking device can break even the brittle substrate having the metal layer formed on the first surface, by one breaking step.

In the breaking device described above, the scribe line may be formed on a second surface opposite to the first surface of the plate-like substrate. In addition, the breaking member may press the plate-like substrate on the first surface so as to break the substrate. In this way, it is possible to reduce damage to the substrate when breaking.

A breaking method according to another aspect of the present invention is a method for breaking a substrate. The breaking method includes:
forming a scribe line on a substrate;
placing on a table the substrate after forming the scribe line; and
pressing the substrate placed on the table at the part where the scribe line is formed, so as to break the substrate along the scribe line.

In the breaking method described above, the table has a Young's modulus of 1 to 10 GPa.

In the breaking method described above, the table on which the substrate to be broken is placed has a Young's modulus of 1 to 10 GPa. By using the table having the appropriate Young's modulus, when pressing the substrate for breaking, the substrate is applied with an appropriate level of force and a displacement in the substrate plane direction, and hence even a substrate that is difficult to break can be broken by one breaking step. If the breaking steps can be reduced, damage to the substrate due to the breaking step can be reduced, and it is possible to suppress occurrence of a large chipping or the like, so that high quality breaking can be realized.

### ADVANTAGEOUS EFFECTS

Because even a substrate that is difficult to break can be broken by one breaking step, damage to the substrate due to the breaking step can be reduced, and high quality breaking can be realized.

### BRIEF DESCRIPTION OF DRAWINGS

Fig. 1 is a diagram illustrating a configuration of a breaking device.
Fig. 2 is a diagram illustrating a configuration of a substrate.
Fig. 3 is a flowchart illustrating a breaking operation of the substrate.
Fig. 4 is a diagram schematically illustrating a manner in which a scribe line is formed on a second principal surface of the substrate.
Fig. 5 is a diagram schematically illustrating a manner in which the substrate is broken.
Fig. 6 is a diagram illustrating a state of a cut part of the substrate in the case where the second table is an acrylic plate.
Fig. 7 is a diagram illustrating a state of the cut part of the substrate in the case where the second table is a metal plate.
Fig. 8 is a diagram illustrating a state of the cut part of the substrate in the case where the second table is a rubber plate.

### DESCRIPTION OF EMBODIMENTS

### 1. First Embodiment

### (1) Breaking Device

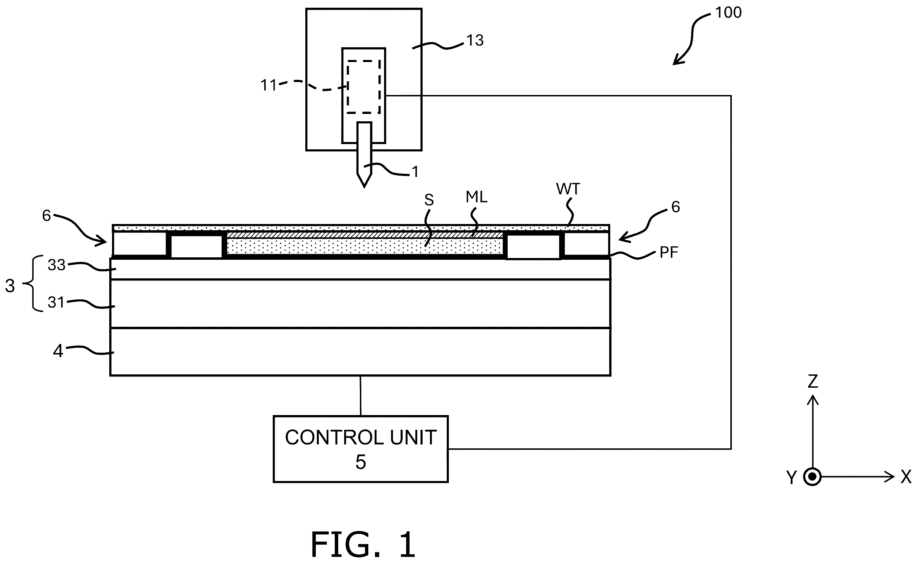

With reference to Fig. 1, a configuration of a breaking device 100 is described. Fig. 1 is a diagram illustrating a configuration of the breaking device. The breaking device 100 is a device for breaking (dividing) a substrate S so as to produce predetermined small substrate units. In Fig. 1, the left and right direction is referred to as an X direction, the normal direction to the page is referred to as a Y direction, and the up and down direction is referred to as a Z direction (height direction). The breaking device 100 mainly includes a breaking member 1, a table 3, and a control unit 5.

The breaking member 1 is held in the breaking device 100 by a holding member 13 including a lifting mechanism 11 such as a guide driven by a motor, for example. The breaking member 1 can move up and down in the Z direction with respect to the table 3. The breaking member 1 is a breaking plate extending in the Y direction, for example.

The substrate S to be broken is placed on the table 3. The table 3 includes a first table 31 and a second table 33. The first table 31 is a hard plate-like member made of a plate-like glass member, for example. The second table 33 is disposed on the first table 31. The substrate S is placed on the second table 33. The second table 33 preferably has a Young's modulus of 1 to 10 GPa, and more preferably has a Young's modulus of 2 to 4 GPa. The second table 33 has a thickness of approximately 1 to 10 mm, for example.

As described later, if the Young's modulus of the second table 33 is in the range described above, it is possible to break the substrate S by one breaking step, and a large chipping does not occur in the cut part of the substrate S. On the other hand, if the Young's modulus of the second table 33 is largely deviated from the range described above, the substrate S cannot be broken by one breaking step, and a large chipping occurs in the cut part of the substrate S.

The second table 33 can be made of, for example, a resin material having the Young's modulus described above, such as an acrylic plate (having a Young's modulus of 2 to 4 GPa), or a polyethylene terephthalate (PET) plate (having a Young's modulus of 2 to 3 GPa).

The second table 33 supports the substrate S together with a dicing frame 6. Specifically, for example, the substrate S is placed so that one principal surface side (the side of the substrate S on which a metal layer ML is disposed) contacts a wafer tape WT attached to the dicing frame 6, a protection tape PF is disposed on the other principal surface side of the substrate S, and the dicing frame 6 is fixed to the second table 33, in the state where an end part of the protection tape PF is sandwiched between the second table 33 and the dicing frame 6, so that the substrate S can be held between the wafer tape WT and the protection tape PF.

The table 3 can be moved by a movement mechanism 4 in the X direction and in the Y direction. In this way, the breaking member 1 can contact the substrate S at any position.

The control unit 5 is a computer system constituted of a CPU, a storage device (such as a RAM, a ROM, an SSD, or an HDD), and various interfaces, so as to control individual portions of the breaking device 100. A part or the whole of functions of controlling the breaking device 100 by the control unit 5 may be realized by executing a program stored in the storage device of the computer system constituting the control unit 5, or a part or the whole of the control functions may be realized by hardware constituting the computer system of the control unit 5.

### (2) Substrate

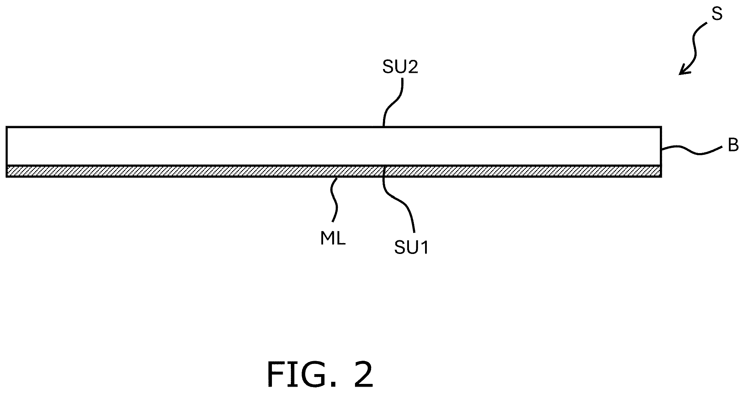

With reference to Fig. 2, a configuration of the substrate S to be broken is described. Fig. 2 is a diagram illustrating a configuration of the substrate. The substrate S includes a plate-like substrate B and the metal layer ML. The plate-like substrate B is, for example, a plate-like substrate made of a single-crystal or polycrystalline brittle material of silicon (Si), silicon carbide (SiC), or other compound semiconductor. The plate-like substrate B has a thickness of approximately 100 µm to 350 µm, for example.

The metal layer ML is a metal film layer disposed on the entire surface of a first principal surface SU1 of the plate-like substrate B. The metal layer ML is mainly intended to be used as a back side electrode, for example. The metal layer ML is a thin film constituted of a layer of titanium (Ti) or nickel (Ni), and a layer of gold (Au) or silver (Ag), for example. The metal layer ML has a thickness of approximately a few µm, for example.

### (3) Breaking Operation of Substrate

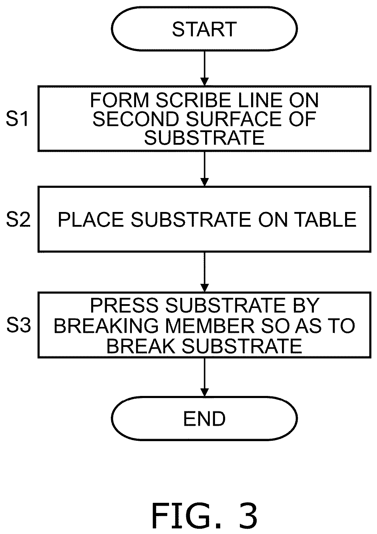

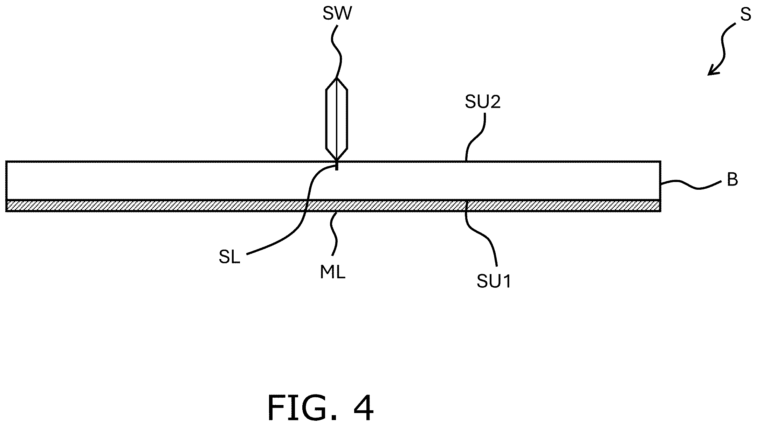

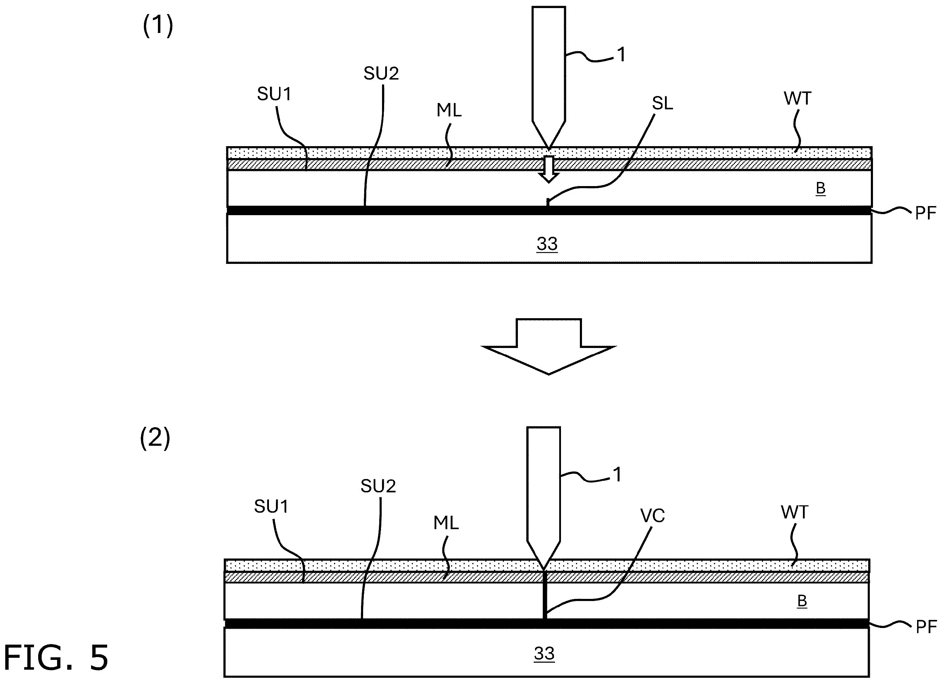

With reference to Figs. 3 to 5, described is the operation of the breaking device 100 when breaking the substrate S described above. Fig. 3 is a flowchart illustrating the breaking operation of the substrate. Fig. 4 is a diagram schematically illustrating a manner in which a scribe line is formed on a second principal surface of the substrate. Fig. 5 is a diagram schematically illustrating a manner in which the substrate is broken.

First, in Step S1, as illustrated in Fig. 4, a scribe line SL is formed along a processing line of the substrate S, on a second principal surface SU2 opposite to the first principal surface SU1 (the surface where the metal layer ML is formed) of the substrate S. The scribe line SL can be formed by moving a scribing wheel SW along the processing line on the second principal surface SU2, while applying a predetermined weight, for example.

After forming the scribe line SL, in Step S2, the substrate S is placed on the table 3 (the second table 33) of the breaking device 100. Specifically, as illustrated in Fig. 5, the wafer tape WT is disposed on the metal layer ML side (the first principal surface SU1 side) of the substrate S, while the protection tape PF is disposed on the second principal surface SU2 side, and the substrate S is placed on the table 3 so that the first principal surface SU1 side (on which the metal layer ML is formed) of the substrate S faces the breaking member 1. After that, as illustrated in Fig. 1, the dicing frame 6 is fixed to the table 3, in the state where the end part of the protection tape PF is sandwiched between the table 3 and the dicing frame 6.

After placing the substrate S on the table 3 of the breaking device 100, in Step S3, the breaking member 1 presses the substrate S placed on the table 3 at the part where the scribe line SL is formed, so as to break the substrate S along the scribe line SL. Specifically, the control unit 5 controls the movement mechanism 4 to move the substrate S so that the scribe line SL is located under the breaking member 1. After that, as illustrated in Fig. 5, the breaking member 1 is moved toward the substrate S, so as to allow the breaking member 1 to press the first principal surface SU1 by a predetermined force, and hence a vertical crack VC extends from the scribe line SL in the thickness direction of the plate-like substrate B toward the first principal surface SU1.

As described above, the second table 33 on which the substrate S is placed has a Young's modulus of 1 to 10 GPa. Therefore, when the breaking member 1 abuts the first principal surface SU1, the breaking member 1 can press the substrate S by an appropriate force. As a result, as illustrated in Fig. 5, the vertical crack VC extends not only in the plate-like substrate B but also in the metal layer ML, and hence the substrate S having the metal layer ML formed on one principal surface can be broken by one breaking step.

### (4) Example

Hereinafter, an example is described in which the substrate S having the metal layer ML formed on the first principal surface SU1 was broken, by performing Steps S1 to S3 described above, using the breaking device 100 having the configuration described above.

In the example described below, using a silicon carbide substrate having a thickness of 100 µm as the plate-like substrate B, layers of titanium, nickel, and gold were formed, i.e. the metal layer ML having a total thickness of 5 µm were formed on the first principal surface SU1 of the plate-like substrate B, so as to make the substrate S, and breaking of the substrate S was tried. In addition, an acrylic plate (having a Young's modulus of 2 to 4 GPa) was used as the second table 33. As comparative examples, using a rubber plate and a metal plate (SUS plate having a Young's modulus of approximately 200 GPa) as the second table 33, breaking of the substrate S described above was tried.

In addition, when using the acrylic plate as the second table 33, the pushing amount of the substrate S by the breaking member 1 was set to 0.22 mm to 0.30 mm. On the other hand, in the comparative examples described above, the pushing amount of the substrate S by the breaking member 1 was set to 0.06 mm to 0.10 mm. The breaking speed was set to 100 mm/s in each case.

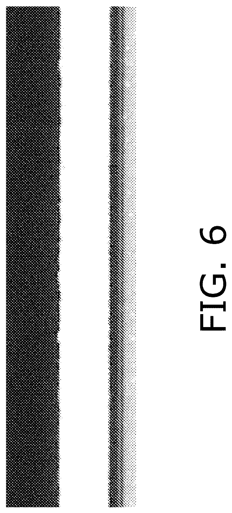

In the case where the second table 33 was the acrylic plate, the plate-like substrate B and the metal layer ML was able to be divided by one breaking step. Fig. 6 illustrates a state of the cut part of the substrate S in the case where the second table 33 was the acrylic plate. As illustrated in Fig. 6, in the case where the second table 33 was the acrylic plate, the cut part of the substrate S had no large irregularity (chipping), and the substrate S was broken with high quality.

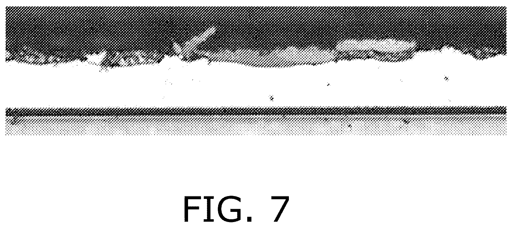

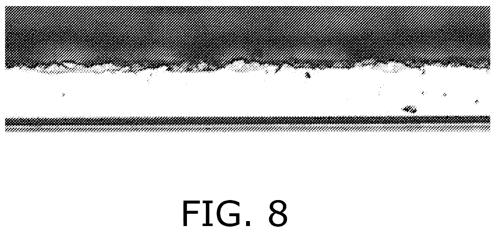

On the other hand, in the case where the second table 33 was the rubber plate or the metal plate, the substrate S was not able to be broken by one breaking step. Therefore, after one breaking step, the substrate S was reversed so that the second principal surface SU2 side faces the breaking member 1, and allowed the breaking member 1 to press the second principal surface SU2 side so as to break the substrate S. Fig. 7 illustrates a state of the cut part of the substrate S in the case where the second table 33 was the metal plate. Fig. 8 illustrates a state of the cut part of the substrate S in the case where the second table 33 was the rubber plate.

As illustrated in Figs. 7 and 8, if the Young's modulus of the table on which the substrate S is placed (i.e., the second table 33) was too small or too large compared with the range described above, the substrate S having the metal layer ML was not able to be broken by one breaking step. As a result, a large irregularity (chipping) occurred in the cut part of the substrate S.

In this way, if the second table 33 has an appropriate Young's modulus of 1 to 10 GPa, when the breaking member 1 presses the substrate S, the substrate S is applied with an appropriate level of force and a displacement in the principal surface direction of the substrate S, and hence even the substrate S that is difficult to break can be broken by one breaking step. If the breaking steps can be reduced, damage to the substrate S due to the breaking step can be reduced, and it is possible to suppress occurrence of a large chipping or the like, so that high quality breaking can be realized.

In addition, if the substrate S can be broken by one breaking step, the step of reversing the substrate S so as to perform breaking again is not necessary, and hence the period of time for breaking the substrate S can be shortened.

### 2. Other Embodiments

Although a plurality of embodiments of the present invention are described above, the present invention is not limited to the embodiments described above, and can be variously modified within the scope of the invention without deviating the spirit thereof. In particular, a plurality of embodiments and variations described in this specification can be arbitrarily combined as necessary.
(A) Using the breaking method described in the first embodiment, it is possible to securely break not only the metal layer ML constituted of a titanium or nickel layer and a gold or silver layer, but also, for example, the metal layer ML constituted of aluminum (Al), the metal layer ML constituted of copper (Cu), the metal layer ML constituted of silver (Ag), the metal layer ML constituted of palladium (Pd), and the metal layer ML constituted of platinum (Pt).
(B) It may be possible to form the entire table 3 using a material having a Young's modulus of 1 to 10 GPa (e.g., a resin material).

### 3. Features of Embodiments

The embodiments described above can also be described as follow.
(1) A breaking device (e.g., the breaking device 100) includes a table (e.g., the table 3) and a breaking member (e.g., the breaking member 1). A substrate (e.g., the substrate S) on which a scribe line (e.g., the scribe line SL) is formed is placed on the table. The breaking member presses the substrate placed on the table at the part where the scribe line is formed, so as to break the substrate along the scribe line. In this breaking device, the table has a Young's modulus of 1 to 10 GPa.
   In the breaking device described above, the table on which the substrate to be broken is placed has a Young's modulus of 1 to 10 GPa. By using the table having the appropriate Young's modulus, when the breaking member presses the substrate, the substrate is applied with an appropriate level of force and a displacement in the substrate plane direction, and hence even a substrate that is difficult to break can be broken by one breaking step. If the breaking steps can be reduced, damage to the substrate due to the breaking step can be reduced, and it is possible to suppress occurrence of a large chipping or the like, so that high quality breaking can be realized.
(2) In the breaking device (1) described above, the table may be made of a resin material. The table made of a resin material has a Young's modulus suitable for breaking a substrate, and hence even a substrate that is difficult to break can be broken by one breaking step, and high quality breaking can be realized.
(3) In the breaking device (1) or (2) described above, the table may include a first table (e.g., the first table 31) made of a glass member and a second table (e.g., the second table 33) disposed on the first table. In this case, the second table may have a Young's modulus of 1 to 10 GPa. In this way, the table having an appropriate hardness can be realized.
(4) In the breaking device of any one of (1) to (3) described above, the substrate may include a plate-like substrate (e.g., the plate-like substrate B) made of a brittle material, and a metal layer (e.g., the metal layer ML) formed on a first surface (e.g., the first principal surface SU1) of the plate-like substrate. The breaking device can break even the brittle substrate having the metal layer formed on the first surface, by one breaking step.
(5) In the breaking device of any one of (1) to (4) described above, the scribe line may be formed on a second surface (e.g., the second principal surface SU2) opposite to the first surface of the plate-like substrate. In addition, the breaking member may press the plate-like substrate on the first surface so as to break the substrate. In this way, it is possible to reduce damage to the substrate when breaking.
(6) A breaking method of a substrate includes:
   forming a scribe line on a substrate (e.g., Step S1);
   placing on a table the substrate after forming the scribe line (e.g., Step S2); and
   pressing the substrate placed on the table at the part where the scribe line is formed, so as to break the substrate along the scribe line (e.g., Step S3).

In the breaking method described above, the table has a Young's modulus of 1 to 10 GPa.

In the breaking method described above, the table on which the substrate to be broken is placed has a Young's modulus of 1 to 10 GPa. By using the table having the appropriate Young's modulus, when pressing the substrate for breaking, the substrate is applied with an appropriate level of force and a displacement in the substrate plane direction, and hence even a substrate that is difficult to break can be broken by one breaking step. If the breaking steps can be reduced, damage to the substrate due to the breaking step can be reduced, and it is possible to suppress occurrence of a large chipping or the like, so that high quality breaking can be realized.

### INDUSTRIAL APPLICABILITY

The present invention can be widely applied to a device and method for breaking a substrate such as a brittle substrate having metal layer on one surface, which is difficult to break.

### REFERENCE SIGNS LIST

- 100: breaking device
- 1: breaking member
- 11: lifting mechanism
- 13: holding member
- 3: table
- 31: first table
- 33: second table
- 4: movement mechanism
- 5: control unit
- 6: dicing frame
- SW: scribing wheel
- S: substrate
- B: plate-like substrate
- SU1: first principal surface
- SU2: second principal surface
- ML: metal layer
- PF: protection tape
- WT: wafer tape

## Claims

1. A breaking device comprising:
a table on which a substrate on which a scribe line is formed is placed; and
a breaking member configured to press the substrate placed on the table at the part where the scribe line is formed, so as to break the substrate along the scribe line, wherein
the table has a Young's modulus of 1 to 10 GPa.

2. The breaking device according to claim 1, wherein the table is made of a resin material.

3. The breaking device according to claim 1, wherein
the table includes a first table made of a glass member and a second table disposed on the first table, and
the second table has a Young's modulus of 1 to 10 GPa.

4. The breaking device according to claim 1, wherein the substrate includes a plate-like substrate made of a brittle material and a metal layer formed on a first surface of the plate-like substrate.

5. The breaking device according to claim 4, wherein
the scribe line is formed on a second surface opposite to the first surface of the plate-like substrate, and
the breaking member presses the plate-like substrate on the first surface so as to break the substrate.

6. A method for breaking a substrate comprising:
forming a scribe line on the substrate;
placing on a table the substrate after forming the scribe line; and
pressing the substrate placed on the table at the part where the scribe line is formed, so as to break the substrate along the scribe line, wherein
the table has a Young's modulus of 1 to 10 GPa.
